# EUROPEAN PATENT APPLICATION

(11) **EP 1 959 027 A1**
(43) Date of publication of application: **20.08.2008**
(21) Application number: 06823562.1
(22) Date of filing: 04.12.2006
(51) Int. Cl.: C23C 14/34, H05H 1/48

(54) **PLASMA FILM DEPOSITION EQUIPMENT**

(30) Priority: 06.12.2005 JP 2005351577
(71) Applicant: Shinmaywa Industries, Ltd., Takarazuka-shi, Hyogo 665-8550 (JP)
(72) Inventor: MARUNAKA, Masao, Takarazuka-shi, Hyogo 665-8550 (JP); TSUCHIYA, Takayuki, Takarazuka-shi, Hyogo 665-8550 (JP); TERAKURA, Atsuhiro, Takarazuka-shi, Hyogo 665-8550 (JP); TAKEUCHI, Kiyoshi, Takarazuka-shi, Hyogo 665-8550 (JP)
(74) Representative: Neath, Susannah Mairi
(86) International application number: PCT/JP2006/324155
(87) International publication number: WO 2007/066606

(57) **Abstract**

An object of the present invention is to provide a plasma film deposition system which can increase a plasma density and improve a sputtering efficiency by not generating a corner of a sheet plasma and can be operated safely by preventing occurrence of the corner in sheet plasma.

A plasma film deposition system comprises: a plasma gun 1 capable of discharging source plasma toward a transport direction; a sheet plasma deformation chamber 2; a pair of magnetic field generating means 9 provided such that same polarities thereof face each other; a film deposition chamber 3; and a forming magnet coil 6 provided upstream of the pair of magnetic field generating means 9 in the transport direction, wherein the pair of magnetic field generating means 9 and the forming magnet coil 6 generate a magnetic field whose magnetic flux densities in the transport direction are substantially constant at portions of a transport center 100 and their vicinity portions, the portions corresponding to the forming magnet coil 6 and the pair of magnetic field generating means 9.

## Description

### Technical Field

The present invention relates to a plasma film deposition system, and particularly to a sheet plasma film deposition system which forms a film by plasma having a sheet shape.

### Background Art

A sheet plasma film deposition system is an apparatus which: converts cylindrical plasma to have a sheet shape by a repelling magnetic field of permanent magnets provided such that a cylindrical plasma beam is sandwiched therebetween and same polarities thereof face each other; carries out sputtering by using the converted sheet-shaped plasma (hereinafter referred to as "sheet plasma") as an ion source; and thus forms a film.

Disclosed as such sheet plasma film deposition system is a sheet plasma film deposition system which is constructed to include a sheet plasma deformation chamber which generates sheet plasma and a surface treatment chamber which is connected to the sheet plasma deformation chamber, wherein the sheet plasma deformation chamber and the surface treatment chamber are electrically insulated from each other, and have different potentials from each other (Patent Document 1 for example).

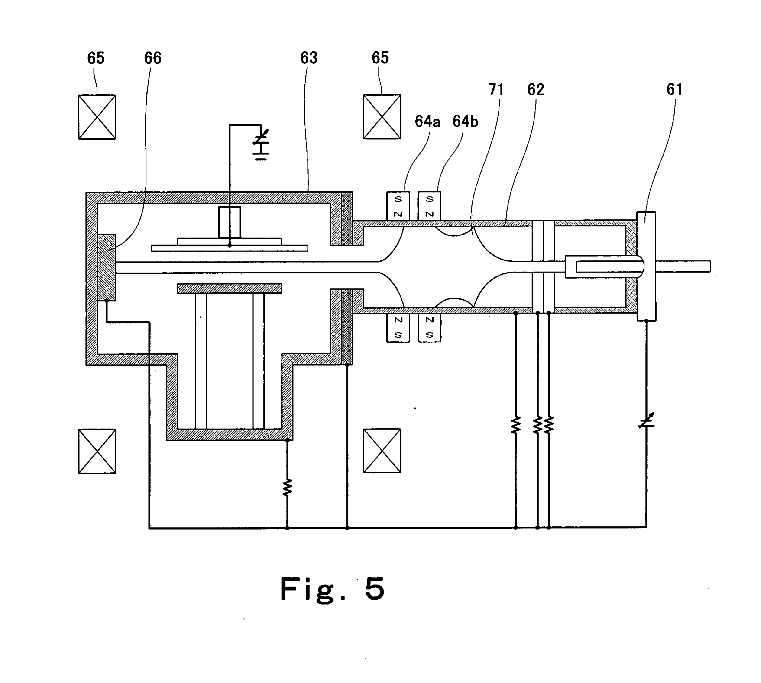

Fig. 5 is a cross-sectional view schematically showing the construction of a conventional sheet plasma film deposition system disclosed in Patent Document 1.

As shown in Fig. 5, the conventional sheet plasma film deposition system includes: a cathode portion 51 which operates as a pressure gradient type plasma source; a sheet plasma deforming chamber 52 which forms sheet-shaped plasma from cylindrical plasma; a surface treatment chamber (sputtering chamber) 53 in which sputtering is carried out; an anode portion 56 which is provided inside the sputtering chamber 53 to receive the sheet-shaped plasma; a pair of permanent magnets 54a and 54b which are provided outside the sheet plasma deforming chamber 52; and a pair of coils 55 which are provided outside the sputtering chamber 53. The system is constructed such that the cylindrical plasma generated by the cathode portion 51 is deformed into the sheet-shaped plasma in the sheet plasma deforming chamber 52 by a magnetic field formed by the permanent magnets 54a and 54b, and the deformed sheet plasma is introduced into the sputtering chamber 53 (to be precise, to the anode portion 56) by a magnetic field of the coils 55.

The sheet plasma film deposition system disclosed in Patent Document 1 is constructed such that the sheet plasma deforming chamber 52 and the sputtering chamber 53 are electrically insulated from each other, and have different potentials from each other. Therefore, since a current does not inevitably flow in the sheet plasma deforming chamber 52, the power loss does not occur. Moreover, since the power loss does not occur, the film can be formed without decreasing the density of the sheet plasma introduced into the sputtering chamber 53.
Patent Document 1: Japanese Patent Publication No. 2952639

### Disclosure of the Invention

### Problems to be Solved by the Invention

However, in a case where the sheet plasma deforming chamber 52 is formed by an insulating material, such as glass, in the sheet plasma film deposition system disclosed in Patent Document 1, the problem is that a part of the formed sheet plasma is absorbed by and spreads (this portion is referred to as "comer 71") toward an inner wall of the sheet plasma deforming chamber 52 by the magnetic field of the permanent magnet 54b, so that the plasma density decreases, and the sputtering efficiency deteriorates. Another problem is that when the plasma near the corner 71 collides with the inner wall of the sheet plasma deforming chamber 52, the sheet plasma deforming chamber 52 is damaged by the heat affect of the energy of the plasma.

The present invention was made to solve the above problems, and an object of the present invention is to provide a plasma film deposition system which does not decrease the plasma density and realizes good sputtering efficiency by preventing occurrence of the corner in sheet plasma. Another object of the present invention is to provide a plasma film deposition system which can be operated safely by preventing occurrence of the corner in sheet plasma.

### Means for Solving the Problems

To solve the above problems, a plasma film deposition system according to the present invention comprises: a plasma gun capable of generating, by electric discharge, source plasma which distributes at a substantially uniform density with respect to a center in a plasma transport direction and discharging the source plasma toward the transport direction; a sheet plasma deformation chamber having a transport space extending in the transport direction; a pair of magnetic field generating means provided such that a transport center of the discharged source plasma is sandwiched therebetween and same polarities thereof face each other; a film deposition chamber having a film deposition space connected to the transport space; and a forming magnet coil provided upstream of the pair of magnetic field generating means in the transport direction so as to penetrate the transport center, wherein the pair of magnetic field generating means and the forming magnet coil generate a magnetic field whose magnetic flux densities in the transport direction are substantially constant at portions of the transport center and their vicinity portions, the portions corresponding to the forming magnet coil and the pair of magnetic field generating means.

With this, since the sheet plasma does not have the corner, the plasma density of the formed sheet plasma can be maintained at a high level, and the sputtering efficiency improves. Moreover, since the sheet plasma does not have the corner, collision of excessive plasma with respect to the inner wall of the sheet plasma deformation chamber does not occur. Therefore, it is possible to suppress the damage of the sheet plasma deformation chamber, and also possible to operate the plasma film deposition system safely.

It is preferable that the pair of magnetic field generating means and the forming magnet coil be provided close to each other.

It is preferable that the pair of magnetic field generating means and the forming magnet coil generate the magnetic field whose magnetic flux densities in the transport direction are 100 to 600G at the portions of the transport center and the vicinity portions, the portions corresponding to the forming magnet coil and the pair of magnetic field generating means.

### Effects of the Invention

In accordance with the plasma film deposition system of the present invention, since the plasma density of the sheet plasma can be maintained at a high level, the sputtering efficiency improves, and the plasma film deposition system can be operated safely by suppressing the damage of the sheet plasma deformation chamber.

### Brief Description of the Drawings

[Fig. 1] Fig. 1 is a cross-sectional view schematically showing the construction of a plasma film deposition system according to Embodiment 1 of the present invention.
[Fig. 2] Fig. 2 is a cross-sectional view taken along line III-III of Fig. 1 showing the plasma film deposition system.
[Fig. 3] Fig. 3 is a graph showing measured magnetic flux densities of the plasma film deposition system shown in Fig. 1.
[Figs. 4] Figs. 4 are schematic diagrams for schematically explaining a method for forming sheet plasma.
[Fig. 5] Fig. 5 is a cross-sectional view schematically showing the construction of a conventional plasma film deposition system.

### Explanation of Reference Numbers

- 1: plasma gun
- 2: sheet plasma deformation chamber
- 3: vacuum film deposition chamber
- 5: first magnet coil
- 6: forming magnet coil
- 7: second magnet coil
- 8: third magnet coil
- 9: permanent magnet
- 10: discharge space
- 13: target
- 14: target holder
- 14a: first holder portion
- 14b: first supporting portion
- 15: substrate
- 16: substrate holder
- 16a: second holder portion
- 16b: second supporting portion
- 17: main power supply
- 18: bias power supply
- 19: bias power supply
- 21: first tubular portion
- 22: second tubular portion
- 23: third tubular portion
- 24: fourth tubular portion
- 25: cathode
- 26: bottleneck portion
- 27: bottleneck portion
- 28: resistor
- 29: resistor
- 30: resistor
- ' 31: flange
- 32a: lid portion
- 32b: lid portion
- 33a: lid portion
- 33b: lid portion
- 34a: lid portion
- 34b: lid portion
- 36: anode
- 37: piping
- 38: first vacuum pump connecting port
- 39: second vacuum pump connecting port
- 40: transport space
- 42: through hole
- 43: slit hole
- 44: slit hole
- 45: slit hole
- 46: slit hole
- 47: valve
- 48: valve
- 49: cylindrical plasma
- 50: sheet plasma
- 51: film deposition space
- 52: permanent magnet
- 61: cathode portion
- 62: sheet plasma deforming chamber
- 63: sputtering chamber
- 64a: permanent magnet
- 64b: permanent magnet
- 65: coil
- 66: anode portion
- 71: corner
- 100: transport center
- G1: first grid electrode (first intermediate electrode)
- G2: second grid electrode (second intermediate electrode)
- S: main surface

### Best Mode for Carrying Out the Invention

Hereinafter, a preferred embodiment of the present invention will be explained in reference to the drawings.

### Embodiment 1

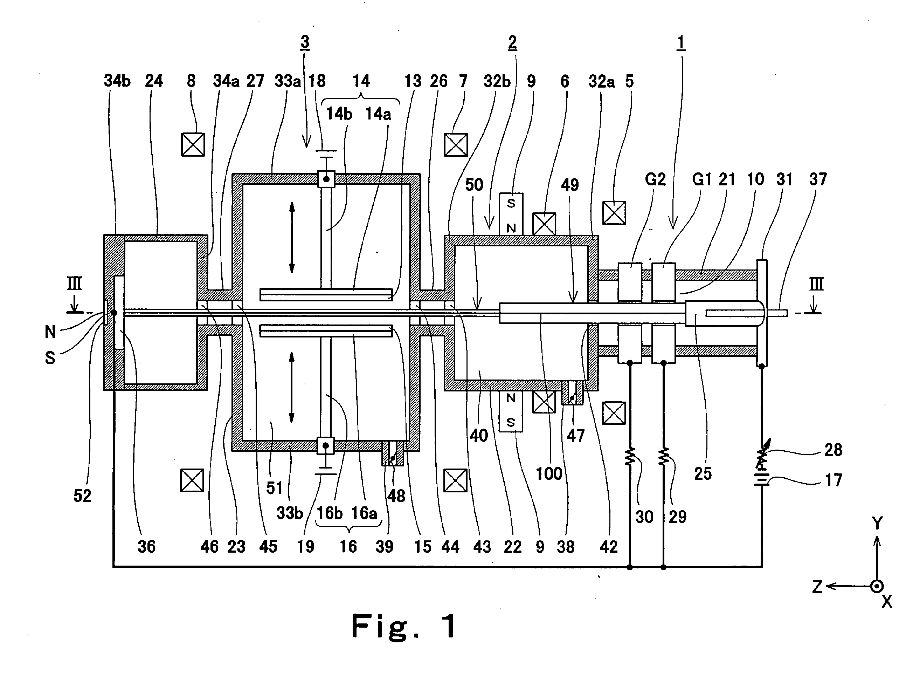

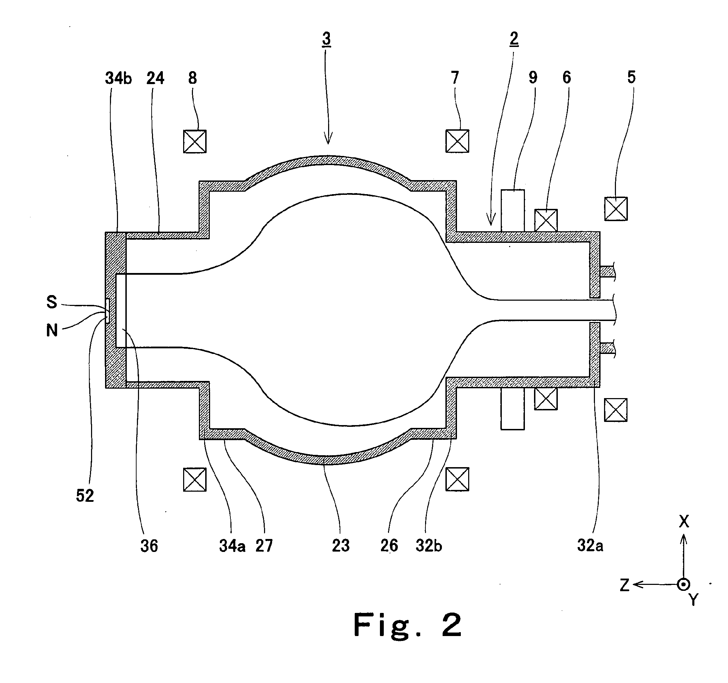

Fig. 1 is a cross-sectional view schematically showing the construction of a plasma film deposition system according to Embodiment 1 of the present invention. Fig. 2 is a cross-sectional view taken along line III-III of Fig. 1, showing the plasma film deposition system. As shown in Fig. 1, an X-axis, a Y-axis and a Z-axis are shown for convenience. Similarly, in Fig. 2, the X-axis, the Y-axis and the Z-axis are shown. In addition, some components or members are omitted in Fig. 2.

First, the construction of the plasma film deposition system according to Embodiment 1 will be explained in reference to Fig. 1.

As shown in Fig. 1, the plasma film deposition system according to Embodiment 1 is constructed to have a substantially cross shape on a Y-Z plane, and includes, in this order when viewed from a plasma transport direction (Z direction), a dual type plasma gun 1 which generates high-density plasma, a cylindrical non-magnetic (for example, stainless steel or glass) sheet plasma deformation chamber 2 whose center is an axis in the Z direction, and a cylindrical non-magnetic (for example, stainless steel) vacuum film deposition chamber 3 whose center is an axis of the Y direction. The plasma gun 1, the sheet plasma deformation chamber 2 and the vacuum film deposition chamber 3 are hermetically connected to each other via a passage through which plasma is transported.

The plasma gun 1 has a first tubular portion 21 of a cylindrical shape. A discharge space 10 is formed by an inner space of the first tubular portion 21. A flange 31 is provided at one end portion of the first tubular portion 21 so as to close the discharge space 10. A cathode 25 is hermetically provided inside the first tubular portion 21 so as to penetrate a center portion of the flange 31 and extend along a central axis (Z-axis) of the first tubular portion 21. The cathode 25 discharges plasma discharge inducing thermoelectrons and is electrically connected via a resistor 28 to a negative terminal of a main power supply 17 that is constituted of a DC power supply. Moreover, a piping 37 is hermetically provided inside the first tubular portion 21 so as to penetrate the center portion of the flange 31 and extend along the central axis (Z-axis) of the first tubular portion 21. Inactive gas, such as argon (Ar) gas, is supplied from the piping 37 to the plasma gun 1 (to be precise, to the discharge space 10).

Moreover, the plasma gun 1 includes a first grid electrode (first intermediate electrode) G1 and a second grid electrode (second intermediate electrode) G2. Each of the first grid electrode G1 and the second grid electrode G2 is hermetically provided on the peripheral surface of the first tubular portion 21. To maintain plasma discharge (glow discharge) between the first grid electrode G1 and the cathode 25 and between the second grid electrode G2 and the cathode 25, the first grid electrode G1 is electrically connected to the main power supply 17 and a suitable resistor 29 and receives a predetermined positive voltage, and the second grid electrode G2 is electrically connected to the main power supply 17 and a suitable resistor 30 and receives a predetermined positive voltage. By such plasma discharge, plasma constituted by charged particles (here, Ar⁺ and electrons) is generated in the discharge space-10 of the plasma gun 1.

Herein, adopted as the plasma gun 1 is a dual type plasma gun which realizes high-density plasma discharge between the cathode 25 and an anode 36, will be described later, by the low voltage based on the main power supply 17 and DC arc discharge of the large current, and which is a combination of a known pressure gradient type plasma gun and a composite cathode type plasma gun.

An annular first magnet coil 5 capable of controlling the magnitude of the magnetic force is provided radially outside of the first tubular portion 21 so as to surround the periphery of the side surface of the first tubular portion 21 and be concentric with the first tubular portion 21. By applying current to a winding of the first magnet coil 5, a Z-direction gradient of the magnetic flux density based on the coil magnetic field is generated in the discharge space 10 of the plasma gun 1. By the Z-direction gradient of the magnetic flux density, the charged particles constituting the plasma proceed in the Z direction while circling around the line of magnetic force, so as to move from the discharge space toward the Z direction (direction toward the anode 36), and the plasma constituted by the charged particles is drawn, via a through hole 42 formed between one Z-direction end of the plasma gun 1 and one Z-direction end of the sheet plasma deformation chamber 2, into the sheet plasma deformation chamber 2 as cylindrical source plasma (hereinafter referred to as "cylindrical plasma 49") which distributes at a substantially uniform density with respect to a transport center 100 extending in the Z direction. Note that the first tubular portion 21, the first grid electrode G1, the second grid electrode G2 and the cathode 25 are insulated from each other by suitable means.

The sheet plasma deformation chamber 2 includes a second tubular portion 22 of a cylindrical shape whose center is an axis extending in the Z direction. A transport space 40 is formed by an inner space of the second tubular portion 22. One (first tubular portion 21 side) end portion of the second tubular portion 22 is closed by a lid portion 32a, and the other end portion is closed by a lid portion 32b. A through hole 42 is provided at a center portion of the lid portion 32a. By the through hole 42, a passage between the plasma gun 1 and the sheet plasma deformation chamber 2 is formed. Moreover, at a center portion of the lid portion 32b, a slit hole 43 is formed so as to extend in the X-axis direction. The second tubular portion 22 is hermetically connected to the first tubular portion 21 by suitable means so as to be electrically insulated from and be coaxial with the first tubular portion 21 (share the central axis). The second tubular portion 22 is made of a non-magnetic material, such as glass or SUS, since it becomes easy to cause the magnetic force of the permanent magnet 9, etc. to influence the cylindrical plasma.

At an appropriate position of the second tubular portion 22, a first vacuum pump connecting port 38 which can open and close by a valve 47 is provided. A vacuum pump, not shown, (turbopump for example) is connected to the first vacuum pump connecting port 38. Vacuum drawing is carried out by the vacuum pump. Thus, the pressure in the transport space 40 is quickly reduced to such a degree of vacuum that the cylindrical plasma 49 is transportable.

A pair of square permanent magnets 9 (a pair of magnetic field generating means) are provided outside the second tubular portion 22 so as to sandwich the second tubular portion 22 (to be precise, the transport space 40), be provided such that the same polarities (here, the north poles) thereof face each other, be magnetized in the Y direction, and extend in the X direction.

Moreover, an annular forming magnet coil 6 (air-cored coil) is provided upstream (on the cathode 25 side) of the permanent magnets 9 in the transport direction so as to surround the peripheral surface of the second tubular portion 22 (penetrate the transport center 100). In the winding of the forming magnet coil 6, current flows in such a direction that the cathode 25 side is the south pole, and the anode 36 side is the north pole.

By the current flowing in the winding of the forming magnet coil 6 and the interaction between the coil magnetic field formed in the transport space 40 of the sheet plasma deformation chamber 2 and the magnet magnetic field formed in the transport space 40 by the permanent magnets 9, the cylindrical plasma 49 moves in the transport space 40 of the sheet plasma deformation chamber 2 in the transport direction (Z direction). During this time, the cylindrical plasma 49 is deformed into uniform sheet-shaped plasma (hereinafter referred to as "sheet plasma 50") which spreads along an X-Z plane (hereinafter referred to as "main surface S") including the transport center 100 in the transport direction.

The sheet plasma 50 deformed as above flows into the vacuum film deposition chamber 3 through a slit-shaped bottleneck portion 26 formed between the lid portion 32b of the second tubular portion 22 and the side wall of the vacuum film deposition chamber 3.

The vacuum film deposition chamber 3 includes: a third tubular portion 23 of a cylindrical shape which has the central axis in the Y-axis direction; and a fourth tubular portion 24 which is connected to the third tubular portion 23 via a bottleneck portion 27 and has the central axis in the Z-axis direction. A film deposition space 51 is formed by an inner space of the third tubular portion 23. One of the end portions of the third tubular portion 23 is closed by a lid portion 33a, and the other end portion is closed by a lid portion 33b.

A slit hole 44 extending in the X-axis direction is formed at a center portion of the peripheral surface on the second tubular portion 22 side of the third tubular portion 23. The tubular bottleneck portion 26 having a square cross section is hermetically provided on the slit hole 44 so that the inner space of the third tubular portion 23 and the inner space of the second tubular portion 22 are connected to each other. The bottleneck portion 26 is hermetically connected to the slit hole 43 provided on the lid portion 32b. The height (size in the Y direction), length (size in the Z direction) and width (size in the X direction) of the bottleneck portion 26 are designed such that the bottleneck portion 26 allows the sheet plasma 50 to appropriately pass therethrough. Moreover, the width of each of the slit holes 43 and 44 may be larger than the width of the deformed sheet plasma 50, and is designed to be a suitable size. Thus, it is possible to prevent extra argon ions (Ar⁺) and electros, which do not constitute the sheet plasma 50, from being introduced into the vacuum film deposition chamber 3, and also possible to maintain the density of the sheet plasma 50 at a high level.

A target 13 and a substrate holder 16 are provided inside the third tubular portion 23 so as to sandwich the sheet plasma 50 and face each other. The target 13 is held by a target holder 14, and the target holder 14 includes a first holder portion 14a and a first supporting portion 14b. The first supporting portion 14b is constructed to hermetically and slidably penetrate the lid portion 33a, be connected to a drive mechanism, not shown, and be movable in the Y-axis direction. Moreover, the target holder 14 is electrically connected to a bias power supply 18. The bias power supply 18 applies a negative bias voltage to the first holder portion 14a for the sheet plasma 50. The first supporting portion 14b of the target holder 14 and the lid portion 33a are insulated from each other. Meanwhile, the substrate holder 16 holds a substrate 15. The substrate holder 16 includes a second holder portion 16a and a second supporting portion 16b. The second supporting portion 16b is constructed to hermetically and slidably penetrate the lid portion 33b, be connected to a drive mechanism, not shown, and be movable in the Y-axis direction. Moreover, the substrate holder 16 is electrically connected to a bias power supply 19. The bias power supply 19 applies a negative bias voltage to the second holder portion 16b for the sheet plasma 50. The second supporting portion 16b of the substrate holder 16 and the lid portion 33b are insulated from each other and connected to each other. Although the bias power supply 18 connected to the target holder 14 and the bias power supply 19 connected to the substrate holder 16 are separately provided, these bias power supplies may be constituted of a common bias power supply. Further, the target holder 14 and substrate holder 16 may be connected to the main power supply 17. However, by separately providing the bias power supplies for the target holder 14 and the base material holder 16, the distance between the target 14 and the substrate 16 can be set freely, and the negative bias voltage can be applied to both the target 14 and the substrate 16. As a result, the sputtering efficiency improves.

Moreover, at an appropriate position of the lid portion 33b, a second vacuum pump connecting port 39 which can be opened and closed by a valve 48 is provided. A vacuum pump, not shown, is connected to the second vacuum pump connecting port 39. Vacuum drawing is carried out by the vacuum pump (turbopump for example). Thus, the pressure in the film deposition space 51 is quickly reduced to such a degree of vacuum that the sputtering can be carried out.

A second magnet coil 7 and a third magnet coil 8 which are capable of controlling the magnitude of the magnetic force are provided outside the third tubular portion 23 so as to form a pair and penetrate the transport center 100. The second magnet coil 7 and the third magnet coil 8 are provided such that different polarities thereof face each other (here, the north pole of the second magnet coil 7 and the south pole of the third magnet coil 8 face each other).

By the coil magnetic field (about 10G to 300G for example) formed by causing current to flow in the windings of the second magnet coil 7 and the third magnet coil 8, while the sheet plasma 50 moves in the Z direction so as to go through the film deposition space 51 of the vacuum film deposition chamber 3, the shape of the sheet plasma 50 in the width direction (X direction) is shaped so that the diffusion in the width direction is appropriately suppressed as a mirror magnetic field.

Moreover, the vacuum film deposition chamber 3 includes the fourth tubular portion 24 which is connected to the third tubular portion 23 via the bottleneck portion 27 and has the central axis in the Z-axis direction. One (third tubular portion 23 side) end portion of the fourth tubular portion 24 is closed by a lid portion 34a, and the other side surface is closed by a lid portion 34b. A slit hole 46 extending in the X-axis direction is formed at a center portion of the lid portion 34a. The tubular bottleneck portion 27 having a square cross section is hermetically provided on the slit hole 46 so that the inner space of the fourth tubular portion 24 and the inner space of the third tubular portion 23 are connected to each other. The bottleneck portion 27 is hermetically connected to a slit hole 45 which is formed at a center portion of the peripheral surface of the third tubular portion 23 so as to extend in the X-axis direction. As with the bottleneck portion 26, the height (size in the Y direction), length (size in the Z direction) and width (size in the X direction) of the bottleneck portion 27 are designed such that the bottleneck portion 27 allows the sheet plasma 50 to appropriately pass therethrough. Moreover, the height and width of each of the slit holes 45 and 46 are set in the same manner as those of the slit holes 43 and 44.

The anode 36 is provided on an inner surface of the lid portion 34b and is electrically connected to a positive terminal of the main power supply 17. A suitable positive voltage (100V for example) is applied between the anode 36 and the cathode 25. With this, the anode 36 serves to collect the charged particles (especially, electrons) in the sheet plasma 50 by the DC arc discharge between the cathode 25 and the anode 36.

A permanent magnet 52 is provided on a rear surface (surface opposite a surface facing the cathode 25) of the anode 36 such that an anode 36 side thereof is the south pole, and an air side thereof is the north pole. Thus, by the line of magnetic force which is emitted from the north pole of the permanent magnet 52 and enters into the south pole of the permanent magnet 52 so as to proceed along the X-Z plane, the sheet plasma 50 may be reduced in width so that the diffusion in the width direction (X direction) of the sheet plasma 50 proceeding toward the anode 36 is suppressed, and thus the charged particles of the sheet plasma 50 may be appropriately collected by the anode 36.

The cross section of each of the first tubular portion 21, the second tubular portion 22 and the fourth tubular portion 24 in the X-axis direction is a circle, however the present invention is not limited to this, and the cross section may be polygonal, etc. Moreover, the cross section of the third tubular portion 23 in the Z-axis direction is a circle, however the present invention is not limited to this, and the cross section may be polygonal, etc.

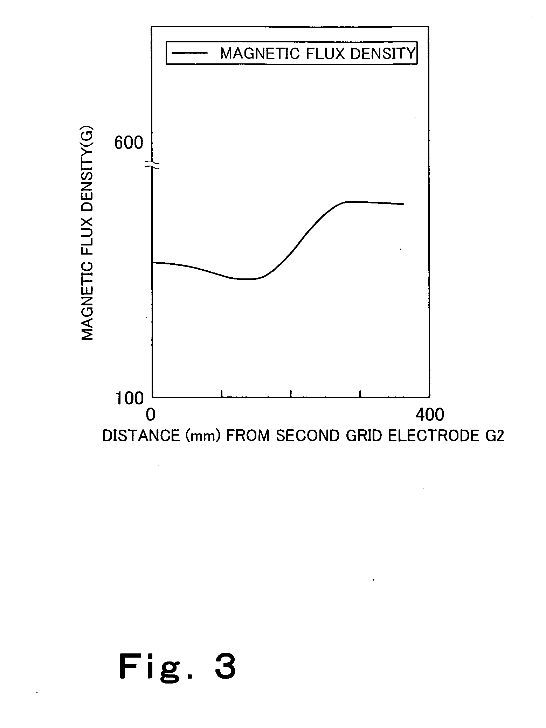

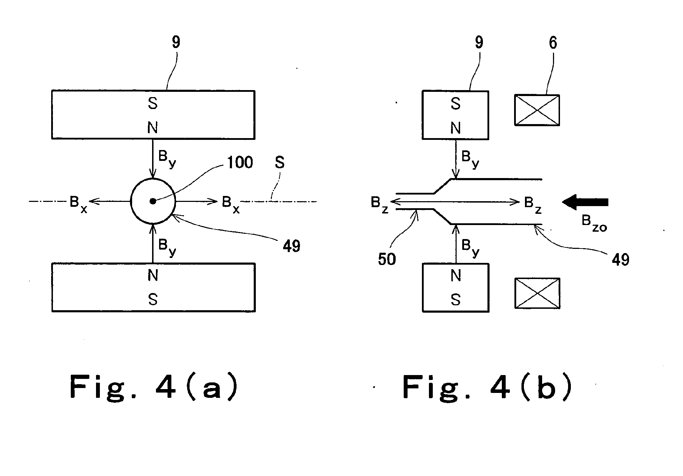

Next, referring to Figs. 3 and 4, the magnetic fields of the permanent magnets 9 and the forming magnet coil 6 in Embodiment 1 will be explained in detail together with a method for deforming the cylindrical plasma 49 into the sheet plasma 50.

Fig. 3 is a graph showing results obtained in such a manner that the magnetic flux densities at the transport center 100 of the plasma transported in the plasma gun 1 and the sheet plasma deformation chamber 2 are detected from the second grid electrode G2 of the plasma film deposition system according to Embodiment 1 shown in Fig. 1 toward the Z-axis direction. Figs. 4 are schematic diagrams for schematically explaining a method for forming the sheet plasma. Fig. 4(a) is a schematic diagram of a cross section parallel to the X-Y plane in the vicinity of a substantially center of a bar magnet in the Z direction, and Fig. 4(b) is a schematic diagram of a cross section parallel to the Y-Z plane in the vicinity of a substantially center of the bar magnet in the X direction.

In Fig. 3, a horizontal axis denotes a distance (mm) from the second grid electrode G2, and a vertical axis denotes the magnetic flux density (G). Moreover, Bx, By and Bz shown in Fig. 4 denote magnetic flux density vector components in the X direction, the Y direction and the Z direction in Fig. 1, respectively.

As shown in Fig. 4(b), an initial magnetic flux density component Bz0 of the cylindrical plasma 49, which acts in the Z-axis direction and has not yet reached the permanent magnets 9, is formed by the magnetic field of the forming magnet coil 6. At this time, the arrangement of the forming magnet coil 6 and the amount of current applied to the winding of the forming magnet coil 6 are set such that the magnitude correlation between the initial magnetic flux density component Bz0 and the magnetic flux density component Bz generated by the pair of permanent magnets 9 in the Z-axis direction become the magnetic flux density shown in Fig. 3. To be specific, the magnetic flux density which is generated by the forming magnet coil 6 and the permanent magnets 9 and is at the transport center 100 proceeds in the Z-axis direction so as to first decrease and then increase as the plasma proceeds from the second grid electrode G2 toward the Z-axis direction. Then, the forming magnet coil 6 and the permanent magnets 9 are provided and their magnetic forces are adjusted such that the density becomes substantially constant (here, 350G) at portions of the transport center 100 and their vicinity portions, the portions corresponding to the forming magnet coil 6 and the permanent magnets 9.

Since the forming magnet coil 6 and the permanent magnets 9 are adjusted (especially, the magnetic flux density is adjusted to be substantially constant at the portions of the transport center 100 and their vicinity portions, the portions corresponding to the forming magnet coil 6 and the permanent magnets 9), the magnetic force returning toward the plasma gun 1 which force is part of the magnetic force generated from the permanent magnets 9 is canceled by the magnetic force generated from the forming magnet coil 6. Therefore, since part of the sheet plasma does not diffuse toward an inner wall of the second tubular portion 22 constituting the sheet plasma deformation chamber 2, the corner is not generated.

From the viewpoint that the magnetic force returning toward the plasma gun 1 which force is part of the magnetic force generated from the permanent magnets 9 is canceled by the magnetic force generated from the forming magnet coil 6, it is preferable that each of the forming magnet coil 6 and the permanent magnets 9 be spaced apart from the second grid electrode G2 by 300 to 400 mm, although it depends on the output of the plasma gun 1, the size of the plasma deformation chamber 2, the size of the forming magnet coil 6, etc. From the same viewpoint, it is preferable that the forming magnet coil 6 and the permanent magnets 9 be provided close to each other, and it is more preferable that they be provided to contact each other. Further, herein, the forming magnet coil 6 and the permanent magnets 9 are adjusted such that the magnetic flux density generated by the forming magnet coil 6 and the permanent magnets 9 is 350G at the portions of the transport center 100 and their vicinity portions, the portions corresponding to the forming magnet coil 6 and the permanent magnets 9. However, the present invention is not limited to this. For example, the magnetic flux density is preferably 100 to 600G and more preferably 200 to 500G, although it depends on the size of the forming magnet coil 6, the size of the permanent magnets 9, etc.

Next, as shown in Fig. 4(a), on the X-Y plane, a pair of Y direction components By of the magnetic flux density are generated, which approach from respective north pole surfaces of the pair of permanent magnets 9 toward the transport center 100, and a pair of X direction components Bx of the magnetic flux density are generated, which are in parallel with the north pole surfaces of the permanent magnets 9 and proceed from the transport center 100 so as to be away from each other.

Since the north pole surfaces of the permanent magnets 9 are provided to face each other, the pair of Y direction components By of the magnetic flux density cancel each other as they approach from the north pole surfaces toward the transport center 100, so that the Y component of the magnetic flux density has a suitable minus gradient.

As shown by arrows in Fig. 4(a), the gradient of the Y direction component By of the magnetic flux density causes the charged particles to move toward the transport center 100 to compress the cylindrical plasma 49 in the Y direction. With this, the charged particles in the cylindrical plasma 49 proceed toward the transport center 100 while circling around the line of magnetic force.

Meanwhile, by the arrangement of the permanent magnets 9 and an appropriate designing of the magnitude of the magnetic field of the permanent magnets 9, the pair of X direction components Bx of the magnetic flux density can be adjusted so that the X component of the magnetic flux density has a suitable minus gradient as they move away from the transport center 100 toward the X direction.

As shown by arrows in Fig. 4(a), the gradient of the X direction component Bx of the magnetic flux density causes the charged particles to move in such a direction that the cylindrical plasma 49 spreads along the main surface S (X-Z plane). With this, the charged particles in the cylindrical plasma 49 proceed to move away from the transport center 100 while circling around the line of magnetic force.

Thus, while the cylindrical plasma 49 moves in the sheet plasma deformation chamber 2 in the Z direction, the cylindrical plasma 49 is uniformly deformed into the sheet plasma 50 spreading along the main surface S based on the magnetic field interaction by the forming magnet coil 6 and the permanent magnets 9. The width, thickness and density distribution of the charged particles of the sheet plasma 50 are adjustable by suitably changing the magnetic flux densities Bx, By, Bz and Bz0.

Next, operations of the plasma film deposition system according to Embodiment 1 will be explained.

First, a vacuum is formed in the plasma film deposition system by the vacuum drawing of the vacuum pump, not shown. Here, since two vacuum pump connecting ports are provided, it is possible to quickly reduce the pressure in the plasma film deposition system. Then, Ar gas is supplied from the piping 37, provided on the plasma gun 1, into the discharge space 10, and the plasma discharge inducing thermoelectrons are discharged from the cathode 25. Thus, the plasma is generated. The plasma is drawn from the cathode 25 toward the anode 36 side by the electric field generated by the first grid electrode G1 and the second grid electrode G2 and the magnetic field generated by the first magnet coil 5, and is shaped to be cylindrical. The shaped cylindrical plasma 49 passes through the through hole 42 and is introduced into the sheet plasma deformation chamber 2.

The cylindrical plasma 49 introduced into the sheet plasma deformation chamber 2 spreads to have a sheet shape (extend along the Z-Y plane) by the magnetic fields generated from the pair of permanent magnets 9 and the forming magnet coil 6. Thus, the sheet plasma 50 is formed. The sheet plasma 50 passes through the slit hole 43, the bottleneck portion 26 and the slit hole 44, and then is introduced into the vacuum film deposition chamber 3.

The sheet plasma 50 introduced into the vacuum film deposition chamber 3 is changed in shape in the width direction by the magnetic fields generated by the second magnet coil 7 and the third magnet coil 8, and then is introduced into the space between the target 13 and the substrate 15. The negative bias voltage is applied via the target holder 14 to the target 13 for the sheet plasma 50. Moreover, the negative bias voltage is applied via the substrate holder 16 to the substrate 15 for the sheet plasma 50. Since the target 13 is negatively biased, Ar⁺ ion efficiently sputters the target. Atoms constituting the sputtered target 13 pass through the sheet plasma 50 in the perpendicular direction. At this time, the atoms are ionized to positive ions. The positive ions are deposited on the negatively biased substrate 15 and receive electrons. Thus, a film is formed on the substrate 15.

The sheet plasma 50 is reduced in width by the line of magnetic force of the permanent magnet 52, and the charged particles of the sheet plasma 50 are appropriately collected by the anode 36.

Herein, the film formation is carried out in a state where the vacuum is formed in the plasma film deposition system. However, the film may be formed on the substrate 15 by introducing a reactive gas into the vacuum film deposition chamber 3 and using a reactant of the gas and the target.

With this construction, since the sheet plasma does not have the corner in the sheet plasma deformation chamber, the plasma density of the sheet plasma increases, and the sputtering efficiency improves. In addition, since the corner is not generated in the sheet plasma deformation chamber, it is possible to suppress the damage of the sheet plasma deformation chamber. Therefore, it is possible to operate the plasma film deposition system safely.

### Industrial Applicability

A plasma film deposition system of the present invention is useful since the sputtering efficiency improves due to high plasma density of the sheet plasma. In addition, since it is possible to suppress the damage of the sheet plasma deformation chamber, the plasma film deposition system of the present invention is useful as a plasma film deposition system which can operate safely.

## Claims

1. A plasma film deposition system comprising:
a plasma gun capable of generating, by electric discharge, source plasma which distributes at a substantially uniform density with respect to a center in a plasma transport direction and discharging the source plasma toward the transport direction;
a sheet plasma deformation chamber having a transport space extending in the transport direction;
a pair of magnetic field generating means provided such that a transport center of the discharged source plasma is sandwiched therebetween and same polarities thereof face each other;
a film deposition chamber having a film deposition space connected to the transport space; and
a forming magnet coil provided upstream of the pair of magnetic field generating means in the transport direction so as to penetrate the transport center, wherein
the pair of magnetic field generating means and the forming magnet coil generate a magnetic field whose magnetic flux densities in the transport direction are substantially constant at portions of the transport center and their vicinity portions, the portions corresponding to the forming magnet coil and the pair of magnetic field generating means.

2. The plasma film deposition system according to claim 1, wherein the pair of magnetic field generating means and the forming magnet coil are provided close to each other.

3. The plasma film deposition system according to claim 1, wherein the pair of magnetic field generating means and the forming magnet coil generate the magnetic field whose magnetic flux densities in the transport direction are 100 to 600G at the portions of the transport center and the vicinity portions, the portions corresponding to the forming magnet coil and the pair of magnetic field generating means.
